(19) Europäisches Patentamt

European Patent Office

Office européen des brevets

(11) EP 0 831 521 A2

## (12) EUROPEAN PATENT APPLICATION

(43) Date of publication:
25.03.1998 Bulletin 1998/13

(51) Int Cl.$^6$: H01L 21/285

(21) Application number: 97307246.5

(22) Date of filing: 18.09.1997

(84) Designated Contracting States:
AT BE CH DE DK ES FI FR GB GR IE IT LI LU MC NL PT SE
Designated Extension States:
AL LT LV RO SI

(30) Priority: 18.09.1996 US 26930 P

(71) Applicant: TEXAS INSTRUMENTS INCORPORATED
Dallas Texas 75265 (US)

(72) Inventors:
• Mizobuchi, Koichi
  Dallas, Texas 75287 (US)
• Fukuda, Yukio
  Toukai Naka Gun, IB 319-11 (US)

(74) Representative: Darby, David Thomas et al
Abel & Imray
Northumberland House
303-306 High Holborn
London WC1V 7LH (GB)

### (54) Method for forming a silicide region

(57) A method of forming a silicide layer 12 is disclosed herein. A siliciding metal layer 20 is formed over a silicon layer 10. These layers are then heated to a first temperature to form a silicide layer 12. This silicide layer 12 can be substantially of a first phase (e.g., C49, TiSi$_2$).

The silicide layer 12 an then be heated while applying a stress to form a silicide layer 12, possibly substantially of a second phase (e.g., C54, TiSi$_2$). In the preferred embodiment, the stress is applied by depositing a cap layer 14.

FIG. 3a

*FIG. 3b*

*FIG. 3c*

*FIG. 3d*

*FIG. 3e*

*FIG. 3f*

*FIG. 3g*

**Description**

FIELD OF THE INVENTION

This invention generally relates to the fabrication of semiconductor devices and specifically to an improved silicide process.

BACKGROUND OF THE INVENTION

As integrated circuits are made smaller, low resistivity materials are needed as interconnects. Metal silicides such as tungsten (W), titanium (Ti), molybdenum (Mo) and cobalt (Co) polycide are very attractive candidates. Titanium polycide is especially attractive since it indicates lowest resistivity.

Self-aligned silicide (or salicide) processes are presently used for lowering the resistivity of transfer gates and n- or p-type diffused layers. *See e.g.*, Science Forum Corp., "Ti SALICIDE Process," <u>VLSI Process Data Book,</u> p322. But as gate widths become narrower, very shallow junctions will be necessary to avoid short channel effects. Unfortunately, it is difficult to apply conventional titanium salicide processes to devices with shallow junction since the depth from the titanium silicide ($TiSi_2$) interface to the p-n (or n-p ) junction is marginal.

It is known that among refractory metal silicides, $TiSi_2$ is considered to be an optimal choice for applications such as contacts and interconnects on silicon MOS devices. The thin-film reaction of titanium on silicon often results in the formation of $TiSi_2$. The two different crystal structures of $TiSi_2$ most often observed in thin film reactions are the C49 and C54 types. The C49 structure is base-centered orthorhombic and the C54 structure is face-centered orthorhombic. The C54 phase is the only $TiSi_2$ phase which occurs in the binary-phase diagram, and therefore the C49 phase is considered to be metastable. In general, see Jeon et al., "Morphology and phase stability of $TiSi_2$ on Si," J. Appl. Phy. 71 (9), 1 May 1992, pp4269-76.

During fabrication, the metastable C49 structure is formed at a relatively low temperature, for example at about 500°C, while the stable C54 structure is formed at higher temperatures of about 700°C. During formation of a titanium silicide layer, the initial nucleation will be to the metastable C49 phase rather than the C54 phase due to a lower free-energy barrier to nucleation.

Unfortunately, the transition from the C49 phase to the C54 phase is difficult because C54 has high packing density compared with C49. This density difference causes a reduction in volume during the anneal process. However, a thin $TiSi_2$ on a rigid surface, such as a silicon substrate, cannot shrink freely since the adhesive bond before any phase transition restricts reduction of volume and causes a tensile stress. If the volume of the C54 phase $TiSi_2$ is expanded by 1.08 times (if a tensile stress of more than 380MPa is applied), then the total energy of C49 $TiSi_2$ will be less than that of C54 $TiSi_2$. *See* "Theoretical study of stress induced C54-to-C49 transition of $TiSi_2$," Extended Abstracts of the 56th Annual Meeting, 1995, The Japan Society of Applied Physics.

It is known to fabricate a titanium silicide layer using two annealing steps. For example, U.S. Patent 5,043,300 (which issued August 27, 1991) teaches depositing a titanium layer on a cleaned semiconductor wafer. The wafer is then moved from a vacuum deposition chamber to an annealing chamber being careful not to expose it to oxygen-bearing gases. Within the annealing chamber, the wafer is annealed in a nitrogen-bearing atmosphere for about 20 to 60 seconds at a temperature from about 500°C to about 695°C. This process step forms a titanium silicide layer and a layer of titanium nitride over the silicide. In addition, the titanium which had been deposited over silicon oxide surfaces is reacted to form titanium nitride. The wafer temperature is then raised to between about 800°C and 900°C to convert the titanium silicide to a stable phase. The wafer can then be etched to remove titanium nitride.

Two papers were presented at the August 1995 meeting of the Japan Society of Applied Physics in Kanazawa, Japan. In "Theoretical Study on Stress-Induced C54 to C49 Phase Transition of $TiSi_2$," Ohfuti et al. studied theoretically how stress affects the phase transition of $TiSi_2$. In this paper, the authors include a figure which shows the volume dependence of the total energy of C49 and C54 structured $TiSi_2$. The volume is normalized by that of non-stressed C54. The total energy of C54 becomes higher than that of C49 when the volume is expanded over 1.08.

This value corresponds to the tensile stress of 380 MPa, obtained by differentiating the energy versus volume relation.

In this paper, the authors conclude that the phase transition from C49 to C54 may not take place under the tensile stress over 380 MPa.

At this conference, Kawamura et al. also presented a paper entitled "Stress Effects on the C49-C54 Phase Transition of $TiSi_2$." In the formation of $TiSi_2$, the so-called two-step annealing process is generally used. In the first step, Ti/Si bilayer (patterned or non-patterned) is annealed at a low temperature to form C49 phase $TiSi_2$. Then in the second step, C49 phase $TiSi_2$ is annealed at higher temperature to transition to C54 phase. The authors of this paper tried applying compressive stress to enhance the C49 to C54 phase transition by depositing a titanium layer on the backside of the Si wafer.

They deposited Ti layers on both front and back sides and then annealed the wafer at 600°C for fifteen minutes in an Argon atmosphere to form C49 $TiSi_2$ on both sides. After that, they annealed the wafer at 650°C for 30 seconds in argon to form C54 $TiSi_2$.

The paper included a figure which showed how the sheet resistivity of the $TiSi_2$ layer of the frontside decreased as a function of the annealing time (a number of annealing cycles at 650°C for 30 seconds each). The Ti thickness of the backside was varied as another parameter. The results show that the sheet resistivity of $TiSi_2$ decreases rapidly as the backside Ti thickness increases. The authors measured the stress applied to the $TiSi_2$ layer of the frontside and found that a compressive stress was applied when there was the backside $TiSi_2$.

Another known process is the capped silicide process wherein the problems of oxygen contamination are avoided by covering the metal layer with a cap material prior to performing the silicide reaction. A process which uses a cap nitride is taught in U.S. Patent 4,940,509. In this teaching, a siliciding metal is deposited over exposed silicon portions of the wafer being fabricated. Five hundred angstroms of silicon nitride are then deposited over the metal and the device is heated to react the metal with the exposed silicon portions to form a metal silicide. The nitride layer can then be removed without adversely affecting the conductive properties of the silicide layer. If the silicide reaction temperature was less than 700°C, the two coexisting phases C49 and C54 of $TiSi_2$ will have been created. To attain a more satisfactory level of conductivity, the prior art reference teaches subjecting the wafer to a higher temperature anneal after stripping away the unsilicided reactants. Oxide-capped titanium silicide formation is also taught in U.S. Patent No. 4,690,730.

SUMMARY OF THE INVENTION

The present invention teaches a method of forming a silicide region which overcomes problems exhibited by the prior art.

More specifically, the present invention provides a simple method for forming a titanium silicide region which is substantially of the C54 phase. In the preferred embodiment, the method uses two heating steps such that a compressive stress is applied during the second heating step. This unique method facilitates the formation of a high conductivity silicide layer.

In one embodiment, a siliciding metal layer is formed over a silicon layer. These layers are then heated to a first temperature to form a silicide layer. This silicide layer is substantially of a first phase. The silicide layer can then be heated while applying a stress to form a silicide layer of substantially a second phase.

In one embodiment, a silicon layer and a refractory metal are heated to a first temperature to create a silicide. An insulating layer such as an oxide or a nitride is deposited over the silicon region. Then, without removing the insulator, the silicide is heated to a second, higher temperature.

In the preferred embodiment a titanium silicide layer is formed.

After a titanium layer is formed over a silicon region, the device is heated to a first temperature, typically between about 550°C and 600°C. This anneal step will form a titanium silicide layer of substantially the C49 phase. A cap layer (e.g., an oxide or nitride layer) can be formed over the titanium silicide layer. This cap layer is deposited so as to provide a compressive stress to the silicide layer. The silicide layer can then be heated to a second temperature so that titanium silicide of substantially the C54 phase is formed.

Accordingly, in one aspect the present invention teaches the use of cap layer deposition after formation of a C49 titanium silicide. The cap layer has its stress controlled as tensile.

As a result, the stress of C49 titanium silicide is controlled as compressive by this cap layer deposition. The C54 transition from the C49 phase is then well-controlled by minimizing the free energy barrier.

As a result, the present invention provides a practical and low cost method for forming low resistance interconnects. Since the cap layer can be formed using standard materials such as silicon dioxide and silicon nitride, no additional fabrication equipment or difficult processing techniques are necessary.

BRIEF DESCRIPTION OF THE DRAWINGS

The above features of the present invention will be more clearly understood from consideration of the following descriptions in connection with accompanying drawings in which:

Figure 1 is a flow chart of a simplified process;
Figure 2a and 2b illustrate the stress and compression created during the reaction of a silicide region;
Figures 3a-3g illustrate cross-sectional views of various steps during a preferred embodiment process flow;
Figures 4a-4g illustrate various steps during an alternate embodiment process flow; and
Figure 5a-5d illustrate various steps during a second alternate embodiment process flow.

Corresponding numerals and symbols in the different figures refer to corresponding parts unless otherwise indicated.

DETAILED DESCRIPTION OF ILLUSTRATIVE EMBODIMENTS

The making and use of the various embodiments are discussed below in detail. However, it should be appreciated that the present invention provides many applicable inventive concepts which can be embodied in a wide variety of specific contexts.

The specific embodiments discussed are merely illustrative of specific ways to make and use the invention, and do not limit the scope of the invention.

The present invention teaches a method of forming a metal silicide which overcomes many of the shortcomings of prior art methods. In one aspect, the present invention contemplates the application of a stress during formation of the silicide. This stress will facilitate the formation of a silicide region.

In a preferred embodiment, a titanium silicide region is formed.

In order to overcome the prior art difficulties, a cap layer is formed on the titanium silicide region. Control of the stress of the cap layer is proposed.

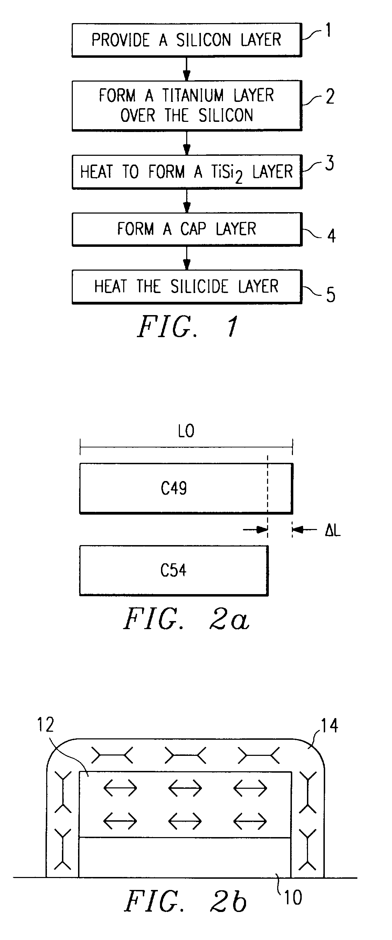

Figure 1 illustrates a simplified process flow for achieving this goal. In Step 1, a silicon layer is provided. A titanium layer is then formed over the silicon layer in Step 2. In Step 3 of the illustrative process flow, the silicon and titanium layers are heated to form a titanium silicide layer. Typically this heating or annealing step is performed at a relatively low temperature and therefore the metastable C49 phase of titanium silicide is formed. In Step 4, a cap layer is formed over the silicide region. The silicide layer along with the cap is then heated at a higher temperature to form C54 phase titanium silicide.

The phase transition from C49 to C54 is difficult because of tensile stress since the C54 phase has a higher packing density than the C49 phase. This difference in packing density causes a difference in volume as illustrated in Figure 2a. In this illustrative example, the C49 phase material is $L_o$ units wide which the C54 phase material is $\Delta L$ units shorter. (The actual material has differences in all three dimensions despite the Figure 2a's one-dimensional illustration.) If the C54 titanium silicide is forced to expand by 1.08 times, the total energy of the C49 phase will be less than that of C54. Therefore, the C49 will become stable under application of tensile stress. In order to facilitate C54 transition from C49, the tensile stress which accompanies the phase transition must be eliminated.

Namely, the tensile stress can be avoided by applying a compressive stress to the C49 layer prior to the phase transition (i.e., prior to the second annealing).

The amount of compressive stress $\sigma$ required for the C49 $TiSi_2$ can be computed.

$$\sigma = E\ \varepsilon = E\ \frac{\Delta L}{L_o} = E\ \frac{1\text{-}1.08}{1} = E\ x\ (\text{-}.08) = 4750x(\text{-}.08) = \text{-}380MPa$$

In this equation, E is the Young's Modulus of C49 $TiSi_2$ and $\Delta L$ and $L_o$ are the dimensions defined in Figure 2a.

In one example, illustrated in Figure 2b, the compressive stress can be achieved by depositing cap layer 14 over the silicide layer 12. The stress within an oxide or a nitride layer 14 can be controlled by varying process conditions such as pressure, temperature, and RF power (if a plasma enhanced process is used). This cap layer 14 can be used to adjust the tensile stress within the titanium silicide layer 12. In Figure 2b, the inward facing arrows in the cap layer 14 are used to note the tensile stress while the outward pointing arrows in titanium silicide layer 12 are used to denote the compressive stress.

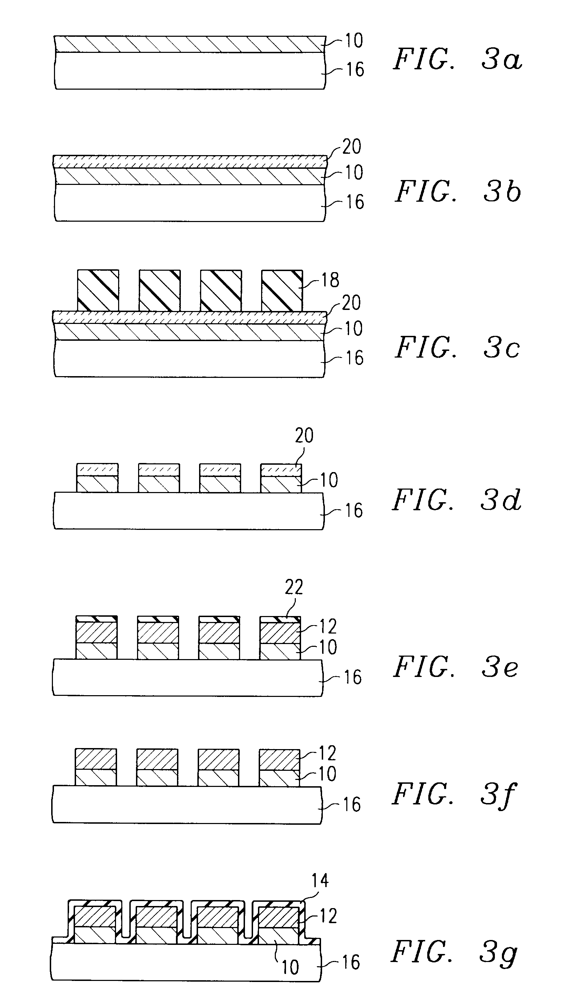

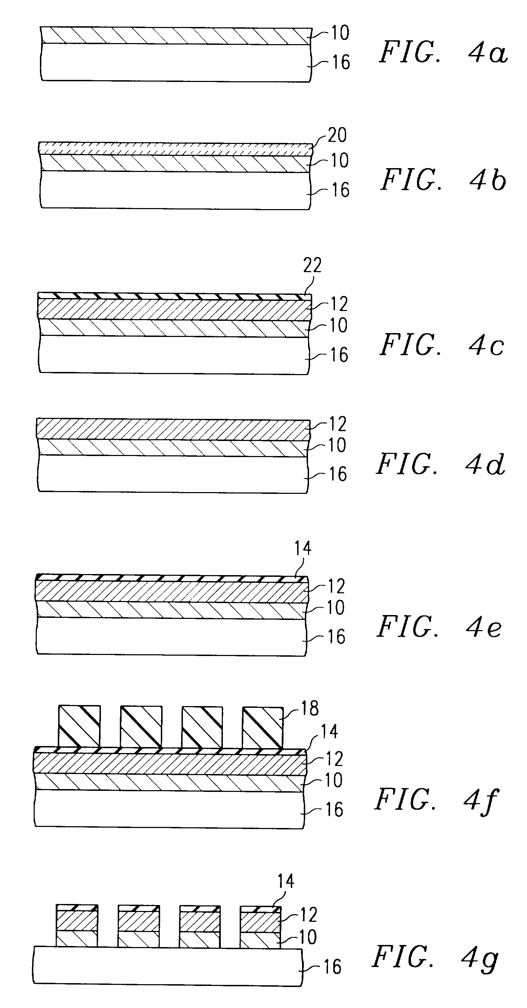

Two exemplary process flows will now be described which utilize this approach. The first flow will be described with reference to Figures 3a-3g and while the second will be described with reference to Figures 4a-4g.

Referring first to Figure 3a, a region 16 is provided. In one embodiment, the region 16 may comprise a silicon dioxide region such as a gate oxide, a field oxide, or an interlevel oxide. In other embodiments different regions are envisioned. For example, the region 16 may be a nitride layer or a semiconductor region. The specific starting material is not critical to the present invention so long as layer 10 will adhere.

A silicon layer 10 is formed over the region 16. In the preferred embodiment, a polycrystalline silicon region is deposited, for example by chemical vapor deposition. This polysilicon layer 10 is preferably doped, although this is not necessary. Further, the silicon region 10 could alternatively comprise amorphous silicon or monocrystalline silicon. It is also possible that the underlying region 16 and silicon layer 10 be a single region.

As illustrated in Figure 3b, a titanium layer 20 is formed over the silicon layer 10. This titanium film 20 may be sputtered or formed by other methods.

As illustrated in Figures 3c and 3d, an interconnect pattern is formed over the silicon and titanium regions 10 and 20. In this embodiment, photoresist layer 18 is patterned and then the polysilicon and titanium layers 10 and 20 are etched using a conventional dry etcher. Other etching techniques could also be utilized.

After the resist material 18 is removed, titanium silicide 12 is formed on the polysilicon layer 10 by heating the regions to a first temperature. This temperature may range from about 500°C to 800°C and is preferably between about 550°C and 600°C. This anneal step can be performed in a nitrogen or nitrogen and hydrogen ambient. The reaction chamber may be kept at a pressure between about 50 and 500 pascal.

The post anneal structure is illustrated in Figure 3e. As shown in the figure, the titanium layer 20 and polysilicon layer 10 have reacted to form titanium silicide regions 12. While some of the polysilicon material 10 remains in the example, it is possible that the entire layer 10 will be consumed by the reaction.

In addition, titanium nitride regions 22 may have been formed above the titanium silicide region 12. As shown in Figure 3f, the unreacted titanium and titanium nitride regions 22 are stripped. This removal can be done using a $NH_4OH$ + $H_2O_2$ dip. The structure illustrated in Figure 3f now has C49 titanium silicide phase 12 formed over polysilicon 10.

A next step in this process flow is to deposit a cap layer 14 over the titanium silicide regions 12. This step can be performed by depositing either an oxide such as silicon dioxide ($SiO_2$) or a nitride such as silicon nitride ($Si_3N_4$) by either low pressure chemical vapor deposition (LPCVD) or plasma enhanced chemical vapor deposition (PECVD).

The tensile stress of the cap layer 14 can be adjusted to adjust the stress of the C49 phase TiSi2 as compressive. The stress of an oxide (or nitride) layer 14 can be varied by varying process conditions during the deposition process. For example, process pressure, RF power and temperature affect the stress of an oxide film formed by PECVD.

Tables 1-3 each provide examples of how stress is varied by varying certain process parameters.

Table 1

| RF POWER | STRESS |
|---|---|
| 360 W | 50 Mpa |
| 450 W | -25 Mpa |
| 540 W | -80 MPa |

Pressure=9 torr; Gas Flow:TEOS=500 sccm, $0_2$=450sccm; Temp.=390°C.

Table 2

| TEMPERATURE | STRESS |
|---|---|
| 312°C | 40 Mpa |
| 390°C | -25Mpa |
| 429°C | -50MPa |

Pressure=9 torr; Power=450w; Gas Flow:TEOS=500sccm, 02=450 sccm.

Table 3

| Low Frequency Power | Oxide Stress | Nitride Stress |
|---|---|---|
| (% of total power) | | |
| 0 | 90 MPa | 500 MPa |
| 20 | -75 MPa | 220 MPa |
| 40 | -210 MPa | -180 MPa |
| 60 | -240 MPa | -470 MPa |

Process Conditions:

Oxide:TEOS=1.8ml/min, $0_2$=5slm, Temp=400°C, pressure=2.2Torr, RF=1Kw
Nitride:$SiH_4$=0.23slm, $NH_3$=2slm, N2=0.6slm, Temp=400°C, Pressure=2.3 Torr, RF=1Kw

The example provided in Table 3 was taken from a paper related to stress control in dual frequency (13.56 MHz/350KHz PECVD oxide and nitride. In this paper, the authors demonstrated that the stress of oxide or nitride films can be controlled by low frequency power. T.H. Wu et al., "Control of Stress, Stability, and Mechanical Properties of PECVD Dielectric Film for GaAs and Si Applications," ECS 9th Symposium of Plasma Processing, No. 131.

The deposition of cap layer 14 in the present invention can be done using a wide variety of processes. For example, CVD oxide (or nitride) deposition techniques include thermal CVD, conventional PECVD, ECR (Electrical Cyclotron Resonance) CVD and dual frequency CVD. The stress of a film formed by any of these can be experimentally controlled by adjusting process conditions. Certainly, the range of stress depends on the particular CVD method. Therefore, the

necessary stress of $TiSi_2$ can be obtained by selecting an adequate CVD method and process conditions.

The necessary stress of cap layer is estimated as follows. The intrinsic stress of C49 $TiSi_2$ at the formation temperature (550-600°C) should be known in advance. The example provided in Table 4 was taken from a paper related to a study on $TiSi_2$ stress. In this paper, the authors describe the stress of $TiSi_2$ at 550-600°C. The additional stress to reach the necessary stress (-380MPa) is also shown in Table 4. If a cap layer is chosen as an oxide or nitride formed by dual frequency PECVD which does not show strong temperature dependence for stress, the TiSi2 stress will be easier to control.

Table 4

| Ti thickness | Estimate $TiSi_2$ thickness | Intrinsic Stress of $TiSi_2$ at 550-600°C | Necessary stress increment to reach 380 MPa | Necessary Stress of Cap Layer thickness: | | |
| --- | --- | --- | --- | --- | --- | --- |
| | | | | 200Å | 500 Å | 1000 Å |
| 300 Å | 600 Å | -250 MPa | -130MPa | 390 MPa | 156 MPa | 78 MPa |
| 600 Å | 1200 Å | -300 MPa | -80 MPa | 480 MPa | 192 MPa | 96 MPa |

In the presently preferred embodiment, a dual frequency CVD process is used. Since a range of stress is widely varied by process conditions, it is fairly easy to achieve the necessary stress by minimizing film thickness. Table 5 provides a range of process parameters for oxide or nitride deposition by dual frequency PECVD. It should be understood, however, that this particular combination of parameters is not unique. With this number of parameters to vary, a large number of combinations can be derived.

Table 5

| Process Parameter | Oxide | Nitride |
| --- | --- | --- |
| Temperature | 400 ± 10 °C | 400 ± 10 °C |
| Pressure | 2.2 ± 0.1 torr | 2.2 ± 0.1 torr |
| Power | 1.0 ± 0.05 kW | 1.0 ± 0.05 kW |
| Low Frequency % | 0 | 0-30 |
| Gas Flow | | |
| TEOS | 1.8 ± 0.1 ml/min. | - |
| $O_2$ | 5 ± 0.2 slm | - |
| $SiH_4$ | - | 0.23 ± 0.01 slm |
| $NH_3$ | - | 2.0 ± 0.1 slm |
| $N_2$ | - | 0.6 ± 0.03 slm |

A second annealing step is performed after the cap layer is in place. This anneal is preferably performed at a temperature between about 700°C and 750°C but more generally in the range between about 700°C and 900°C. This second annealing step will form the C54 phase titanium silicide. In one specific embodiment, the second anneal is performed at a temperature between 700°C and 750°C, a pressure between 50 and 500 Pa in an $H_2+N_2$ or an $N_2$ ambient.

In a less preferred embodiment, the first and second annealing steps can both be performed after formation of the cap layer 14.

The reason this process is less preferred is that it is more difficult to control the stress within cap layer 14. However, the necessary stress control can be achieved by adjusting the process parameters as discussed above and therefore the present invention is intended to encompass this embodiment.

Referring now to Figures 4a-4g, a second embodiment process flow is illustrated. As will be clear, the second process flow is very similar to the first process flow embodiment except now the step of patterning the interconnect is performed after formation of the final silicide region. Processing details described with respect to the first embodiment also apply to this embodiment, and vice-versa.

Referring now to Figures 4a and 4b, silicon layer 10 and titanium layer 20 are formed over region 16 as described previously. The first anneal step can then be performed to form titanium silicide layer 12 and titanium nitride layer 22 (Figure 4c). After the titanium nitride layer 22 is removed in Figure 4d, a cap layer 14 is formed (Figure 4e). As described above, the cap layer may be formed by low pressure chemical vapor deposition or plasma enhanced chemical deposition of a nitride or an oxide layer.

In Figure 4f, resist layer 18 is formed over the device and patterned. The interconnect regions can then be formed as desired. This final structure is illustrated in Figure 4g.

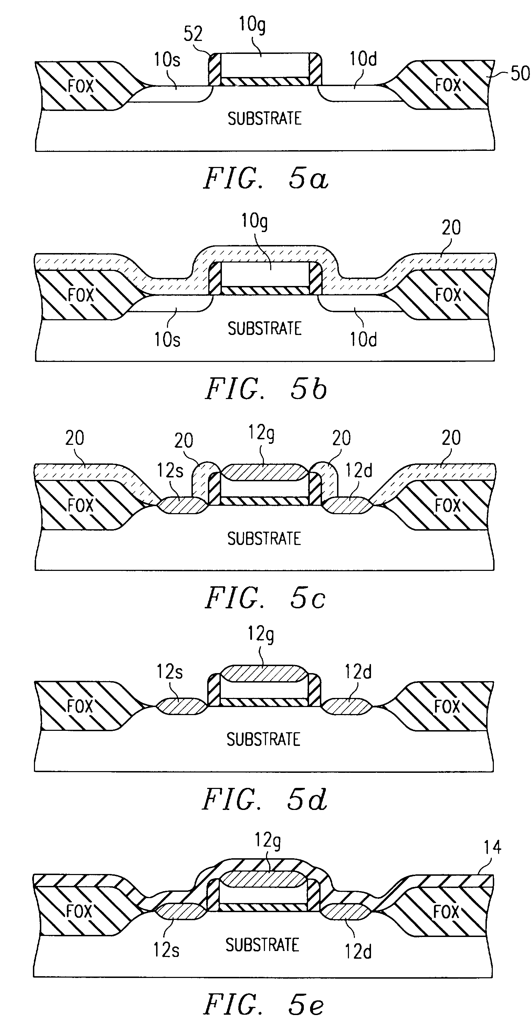

Yet another exemplary embodiment is illustrated in Figures 5a-5e. This embodiment utilizes a self-aligned silicide (salicide) process. In this context, a self-aligned process is one in which no masking step is needed to form a silicide in the desired locations. In these figures, a field effect transistor is shown as an arbitrary example of a device which can be silicided. Referring first to Figure 5a, three silicon layers 10s, 10g and 10d (i.e., the source, gate and drain of the transistor) will be silicided.

As shown in Figure 5b, titanium layer 20 is deposited over the entire transistor device. Any deposition method can be used or other metals can be used, as described elsewhere.

The first anneal step is then performed with the resultant structure illustrated in Figure 5c. As shown, the titanium 20 reacted with any of the silicon layers 10 to which it was exposed. However, the titanium 20 did not react with insulating regions 50 (field oxide) and 52 (sidewall insulator - e.g., sidewall oxide or nitride). As before, this first anneal step creates C49 phase $TiSi_2$.

Referring now to Figure 5d, the extraneous titanium (or titanium nitride or other unwanted by-products) can be removed.

In Figure 5e, cap layer 14 is deposited over titanium silicide regions 12. As described above, the tensile stress of cap layer 14 can be adjusted to adjust stress of the C49 phase $TiSi_2$. This additional stress will facilitate formation of the stable C54 phase $TiSi_2$. The device is then once again heated to convert the C49 phase $TiSi_2$ to C54 phase $TiSi_2$.

While described herein with respect to specific process flows, other modifications are envisioned. For example, the cap layer can be either in an oxide or nitride layer. Experimentation has shown that both $SiO_2$ and $Si_3N_4$ layers formed by dual frequency CVD as the cap layer may be superior but layers formed from other processes can also be used. Experimentation has also shown that a plasma $SiO_2$ layer as a cap layer may be superior even though plasma $Si_3N_4$ layers are also envisioned.

The first and/or second heating steps can be performed in a furnace. For example the device can be heated at the appropriate temperature for a period between about 30 and 90 minutes. Alternatively, rapid thermal processing (RTP) can also be utilized.

The method of the present invention can be applied to a variety of ULSI (or other) circuits. This process can be used to form a contact on the source, drain or gate of a MOS transistor device or a contact on other devices such as bipolar transistors, diodes, capacitors, resistors, and other elements.

The present invention could also be used for interconnects between various elements within an integrated circuit.

Specifically, the present invention would be especially useful for the word lines and bit lines of a dynamic random access memory. The process is especially well-suited for small lithographs such as 0.25 micron line widths.

By using the present invention, low resistivity titanium silicide (e.g., C54 phase) can be formed on the word lines and bit lines of a DRAM (dynamic random access memory). By doing so, access speed can be improved. Speeding up the access speed can maximize the refresh capacity and reduce the area of peripheral circuitry. As a result, chip size can be reduced.

Furthermore, the number of interconnect layers can be decreased by the application of this invention to the word lines and bit lines. Since metal interconnects over word/bit lines are often used for strapping the word/bit line, a low resistance material like $TiSi_2$ can eliminate the number of metal interconnects. This invention therefore offers cost reduction to DRAM manufacturing.

In the multi-phase phenomenon seen in titanium is also observed in other materials. As an example, a tungsten silicide ($WSi_2$) film exhibits hexagonal or tetragonal crystal structures by annealing temperature. In the case of $WSi_2$, the anneal temperature will be around 900°C to obtain low resistivity. But the transition from hexagonal to tetragonal is not the same as the C49-to-C54 transition of $TiSi_2$ and therefore there is not as much difficulty in phase transition.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description.

## Claims

1. A method for forming a titanium silicide region, said method comprising the steps of:

   forming a titanium layer over a silicon layer;

heating the silicon layer and the titanium layer to a first temperature so that the silicon layer and titanium react to form a titanium silicide region;

depositing an insulating layer at least over said titanium silicide region; and

without removing the insulating layer, heating the titanium silicide region to a second temperature, wherein the second temperature is higher than the first temperature.

2. The method of Claim 1, wherein said step of providing a silicon layer comprises depositing a polycrystalline silicon layer.

3. The method of Claim 1 or Claim 2, wherein said step of forming said titanium layer comprises sputtering said titanium layer.

4. The method of any preceding claim, further comprising performing said step of depositing an insulating layer after heating the silicon and titanium to said first temperature.

5. The method of Claim 4, wherein said step of depositing said insulating layer comprises depositing an oxide layer.

6. The method of Claim 4, wherein said step of depositing said insulating layer comprises depositing a nitride layer.

7. The method of any preceding Claim, wherein said heating step comprises heating said silicon layer and said titanium layer to a first temperature between about 550°C and 600°C.

8. The method of any preceding claim, wherein said step of heating said titanium silicide region comprises heating said titanium silicider region to a second temperature between about 700°C and 750°C.

9. The method of any preceding Claim further comprising the step of;
   patterning said titanium and silicon layers.

10. The method of Claim 9, further comprising performing said patterning step before the formation of the titanium silicide region.

11. The method of Claim 9, further comprising performing said patterning step after the formation of the titanium silicide region.

12. The method of any preceding claim, further comprising performing the depositing step by chemical vapor deposition.

13. The method of Claim 12, further comprising performing the depositing step by plasma enhanced chemical vapor deposition.

14. The method of Claim 12, further comprising performing the depositing step by dual frequency chemical vapor desposition.

15. The method of any preceding claim, further comprising performing the depositing step at:

   a temperature between about 350 and 450°C; and
   a pressure between about 2.0 and 2.5 torr.

16. The method of any preceding claim, further comprising forming the titanium silicide region by a self-aligned silicide process.

17. A method for forming a titanium silicide layer comprising the steps of:

   forming a titanium layer over a silicon layer;
   heating the titanium layer and the silicon layer to form a titanium silicide layer of the C49 phase; and
   heating said C49 titanium silicide layer while applying a stress to the top surface of the titanium silicide layer, such that C54 titanium silicide layer is formed.

18. The method of Claim 17, further comprising performing the step of heating the titanium layer and the silicon layer at a lower temperature than the step of heating the titanium silicide layer.

19. The method of Claim 17 or Claim 18, further comprising the step of;
depositing a cap layer, such that said cap layer applies a stress during the step of heating the titanium silicide layer.

20. The method of Claim 19, wherein the step of depositing said cap layer comprises depositing an oxide layer.

21. The method of Claim 19, wherein the step of depositing said oxide layer comprises depositing a CVD oxide layer.

22. A method for forming a titanium silicide layer comprising the steps of:

forming a titanium layer over a silicon layer;
heating the titanium layer and the silicon layer to a first temperature to form a titanium silicide layer of substantially the C49 phase;
depositing a cap layer over the titanium silicide layer such that the cap layer applies a stress to the titanium silicide layer; and
heating the titanium silicide layer to a second temperature so that the titanium silicide layer is substantially of the C54 phase.

23. The method of Claim 22, wherein said heating step comprises heating the silicon layer and the titanium layer to a first temperature between about 550°C and 600°C.

24. The method of Claim 22 or Claim 23, wherein said step of heating said titanium silicide layer comprises heating said titanium silicide layer to a second temperature between about 700°C and 750°C.

25. The method of any of Claims 22 to 24, wherein the step of depositing a cap layer comprises depositing a silicon oxide layer.

26. The method of any of Claims 22 to 24, wherein the step of depositing a cap layer comprises depositing a silicon nitride layer.

27. The method of any of Claims 22 to 26, further comprising the step of patterning the titanium and silicon layers prior to the step of heating the titanium and silicon layers.

28. The method of any of Claims 22 to 26, further comprising the step of patterning the titanium silicide layer after heating the titanium silicide layer to a second temperature.

29. The method of any of Claims 22 to 28, further comprising performing the step of depositing a cap layer after the step of heating the titanium layer and the silicon layer to a first temperature.

30. The method of any of Claims 22 to 28, further comprising performing the step of depositing a cap layer before the step of heating the titanium layer and the silicon layer to a first temperature.

31. The method of any of Claims 22 to 30, further comprising forming the cap layer by dual frequency chemical vapor deposition.

32. The method of any of Claims 22 to 31, further comprising depositing the cap layer at a temperature between about 350 and 450°C and a pressure between about 2.0 and 2.5 torr.

33. The method of any of Claims 22 to 31, further comprising forming the titanium silicide layer with a self-aligned silicide process.

PROVIDE A SILICON LAYER — 1

FORM A TITANIUM LAYER
OVER THE SILICON — 2

HEAT TO FORM A TiSi$_2$ LAYER — 3

FORM A CAP LAYER — 4

HEAT THE SILICIDE LAYER — 5

*FIG. 1*

LO

C49

ΔL

C54

*FIG. 2a*

12        14

10

*FIG. 2b*

FIG. 3a

FIG. 3b

FIG. 3c

FIG. 3d

FIG. 3e

FIG. 3f

FIG. 3g

*FIG. 4a*

*FIG. 4b*

*FIG. 4c*

*FIG. 4d*

*FIG. 4e*

*FIG. 4f*

*FIG. 4g*

FIG. 5a

FIG. 5b

FIG. 5c

FIG. 5d

FIG. 5e